# Europäisches Patentamt
## European Patent Office
## Office européen des brevets

(19)

(11) Veröffentlichungsnummer: **0 098 956**
**B1**

(12) # EUROPÄISCHE PATENTSCHRIFT

(45) Veröffentlichungstag der Patentschrift:
**13.09.89**

(51) Int. Cl.⁴: **G 06 K 7/10**

(21) Anmeldenummer: **83105367.3**

(22) Anmeldetag: **31.05.83**

(54) **Strichcodeleser für Hochfrequenzempfangsgeräte.**

(30) Priorität: **15.07.82 DE 3226410**

(43) Veröffentlichungstag der Anmeldung:
**25.01.84 Patentblatt 84/4**

(45) Bekanntmachung des Hinweises auf die Patenterteilung:
**13.09.89 Patentblatt 89/37**

(84) Benannte Vertragsstaaten:
**AT BE CH FR GB IT LI LU NL SE**

(56) Entgegenhaltungen:
**DE-A-2 757 264**
**GB-A-2 034 995**

(73) Patentinhaber: **Deutsche Thomson- Brandt GmbH,
Hermann- Schwer- Strasse 3 Postfach 1307,
D-7730 Villingen- Schwenningen (DE)**

(72) Erfinder: **Eigeldinger, Norbert, Tulpenstrasse 8,
D-7730 VS- Pfaffenweiler (DE)**
Erfinder: **Otto, Bernhard, Überruckweg 13, D-7730
VS- Rietheim (DE)**

EP 0 098 956 B1

## Beschreibung

### Stand der Technik

Die Erfindung bezieht sich auf einen Strichcodeleser in Anwendung auf Rundfunk-Geräte, Fernsehgeräte und Videorecorder.

Derartige Leser werden dazu benutzt, einen Strichcode, der z. B. in Programmzeitschriften abgedruckt ist und Art und Sendezeiten der verschiedenen Sendeanstalten beinhaltet, auszulesen, um diese Informationen zwecks Programmierung oben angegebener Geräte in diese einzuspeichern. Hierbei werden die Daten der Strichcodeleser mit Hilfe von Leitungen an die Geräte übertragen.

Die oben genannten Empfangs- oder Wiedergabegeräte besitzen meist auch eine Fernbedienung, über welche die verschiedenen Gerätefunktionen geschaltet werden können. Aus DE-A-2 757 264 ist es bekannt, den Lesestab eines Strichcodelesers mit einem Fernbedienungsgeber zu kombinieren und die aufgenommenen Daten drahtlos zum Empfangsgerät zu übertragen. Auf diese Weise ergeben sich für den Besitzer derartiger Geräte immer mehr Möglichkeiten der Bedienung, wodurch jedoch wiederum die Gefahr von Verwechslungen besteht.

### Aufgabe

Der Erfindung liegt deshalb die Aufgabe zugrunde, die Bedienung zu vereinfachen, was durch die in den Patentansprüchen gekennzeichneten Maßnahmen erzielt wird.

### Beschreibung

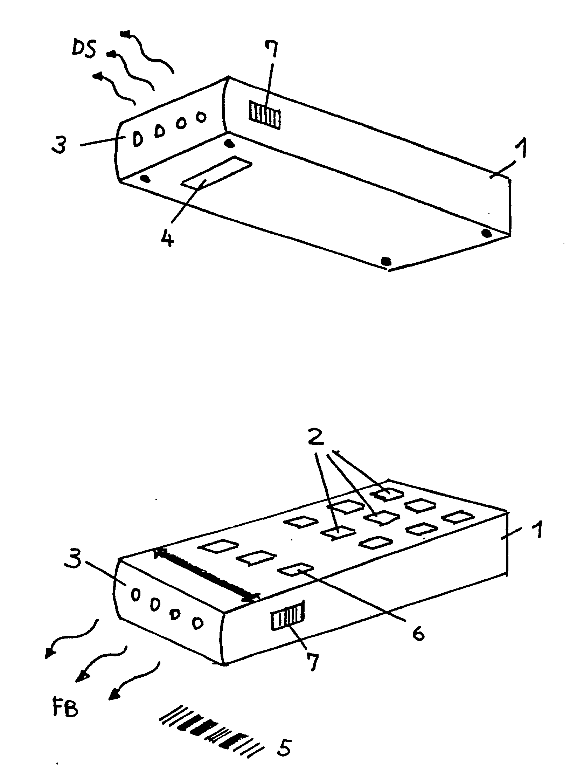

Mit Hilfe der Zeichnung soll nachstehend das Wesentliche der Erfindung beschrieben werden.

Die Figur stellt ein Fernbedienungsgehäuse 1 dar, in welchem sich die elektronische Schaltung für die einzelnen Fernbedienungsbefehle befindet, welche über Tasten 2 ein- und ausschaltbar sind. Die Fernbedienungssignale FB werden mit Hilfe von Infrarotdioden 3 ausgesendet. Zum Auslesen von Strichcodes 5 ist an der Unterseite des Gehäuses 1 die Optik 4 für den Strichcodeleser angeordnet. Die ausgelesenen Daten werden gegebenenfalls zwischengespeichert und über die Infrarotdioden 3 des Fernbedienergeräts als Datensignale DS an den betreffenden Empfänger weitergeleitet, z. B. durch Betätigen einer Taste 6. Zweckmäßigerweise befindet sich an einer Fläche des Gebers 1 eine Taste 7, welche nur während des Auslesens betätigt wird, so daß sie im Ruhezustand automatisch ausgeschaltet bleibt.

## Patentansprüche

1. Strichcodeleser für die Programmierung von Rundfunkgeräten, Fernsehgeräten und Videorecordern, die mit einer drahtlosen Fernbedienung mittels Infrarot- oder Ultraschallsignalen fernbedienbar sind, in Kombination mit einem tastengesteuerten Fernbedienungsgeber, wobei die vom Leser ausgelesenen Daten über die Fernbedienung an das Empfangsgerät übertragbar sind, dadurch gekennzeichnet, daß die Optik (4) des Lesers an einer Seitenfläche des Fernbedienungsgebers (1) angeordnet ist und die elektronische Schaltung für den Leser innerhalb des Fernbedienungsgebers angeordnet ist.

2. Strichcodeleser nach Anspruch 1, dadurch gekennzeichnet, daß sich die Optik (4) auf der Seite der Tasten (2) des Gebers (1) befindet.

3. Strichcodeleser nach Anspruch 1, dadurch gekennzeichnet, daß sich die Optik auf der den Fernbedienungstasten gegenüberliegenden Seite des Gebers befindet.

## Claims

1. Bar code reader for the programming of radio sets, television sets and video recorders which are capable of remote control with a wireless remote control by means of infrared or ultrasonic signals, in combination with a pushbutton-operated remote-control transmitter, the data read out by the reader being transmittable to the receiver via the remote control, characterised in that the optics (4) of the reader are disposed on a lateral surface of the remote-control transmitter (1) and the electronic circuitry for the reader is disposed inside the remote-control transmitter.

2. Bar code reader according to Claim 1, characterised in that the optics (4) are disposed on the same side as the pushbuttons (2) of the transmitter (1).

3. Bar code reader according to Claim 1, characterised in that the optics are disposed on the opposite side of the transmitter to the remote-control pushbuttons.

## Revendications

1. Lecteur de codes à barres pour la programmation d'appareils de radiodiffusion, d'appareils de télévision et d'enregistreurs vidéo, qui peuvent être télécommandés au moyen de signaux infrarouges ou ultrasonores, en combinaison avec un générateur de signaux de télécommande commandé à l'aide de touches, les données lues par le lecteur pouvant être transmises à l'appareil récepteur par l'intermédiaire de la télécommande, caractérisé par le fait que le dispositif optique (4) du lecteur est disposé sur une face latérale du générateur (1) de signaux de télécommande et que le circuit électronique pour le lecteur est disposé à l'intérieur du générateur de signaux de télécommande.

2. Lecteur de codes à barres suivant la revendication 1, caractérisé par le fait que le dispositif optique (4) est situé sur la face portant les touches (2) du générateur (1).

3. Lecteur de codes à barres suivant la revendication 1, caractérisé par le fait que le dispositif optique est situé sur la face du générateur, située à l'opposé des touches de télécommande.